# FASCICULE DE BREVET EUROPEEN

(11) **EP 3 676 879 B1**
(45) Date de publication et mention de la délivrance du brevet: **06.12.2023**
(21) Numéro de dépôt: 18773533.7
(22) Date de dépôt: 28.08.2018
(51) Int. Cl.: H01L 31/048, B29B 17/02, H01L 31/18, B29C 63/00, B32B 43/00, B26D 3/28, B26F 3/12

(54) **PROCEDE DE DESASSEMBLAGE D'UN MODULE PHOTOVOLTAÏQUE ET INSTALLATION ASSOCIEE**
VERFAHREN ZUR DEMONTAGE EINES PHOTOVOLTAIKMODULS UND ZUGEHÖRIGE ANLAGE
METHOD FOR DISASSEMBLING A PHOTOVOLTAIC MODULE AND ASSOCIATED INSTALLATION

(30) Priorité: 30.08.2017 FR 1758010
(43) Date de publication de la demande: 08.07.2020
(73) Titulaire: Commissariat à l'Energie Atomique et aux Energies Alternatives, 75015 Paris (FR)
(72) Inventeur: COUSTIER, Fabrice, 73000 Chambery (FR); MESSAOUDI, Paul, 73230 Saint-Alban Leysse (FR); SERASSET, Marion, 73170 Saint Paul sur Yenne (FR); VELET, Nicolas, 38510 Vezeronce-Curtin (FR)
(74) Mandataire: INNOV-GROUP
(86) Numéro de dépôt international: PCT/FR2018/052113
(87) Numéro de publication internationale: WO 2019/043329

(56) Documents cités:
- EP-A1- 1 830 411
- JP-A- 2009 214 058
- JP-A- 2015 110 201
- US-A1- 2010 197 202
- Anonymous: "Wire saw - Wikipedia", , 27 March 2017 (2017-03-27), pages 1-4, XP055839254, DOI: https://en.wikipedia.org/w/index.php?title =Wire_saw&oldid=772496946 Retrieved from the Internet: URL:https://en.wikipedia.org/w/index.php?t itle=Wire_saw&oldid=772496946 [retrieved on 2021-09-08]

## Description

### Domaine de l'invention

Le domaine de l'invention concerne le désassemblage d'un module photovoltaïque, notamment lorsque le module photovoltaïque arrive en fin de vie, ou lorsque le module photovoltaïque est un rebut de production.

### Etat de la technique

Les modules photovoltaïques sont utilisés pour générer de l'électricité à partir du rayonnement solaire. Un module photovoltaïque comporte de nombreux éléments intéressants à récupérer, notamment dans le cadre d'un recyclage en fin de vie du module photovoltaïque ou en cas de défaillance du module photovoltaïque. Le module photovoltaïque peut comporter une enveloppe d'encapsulation de cellules photovoltaïques assurant aussi un maintien mécanique d'un élément de protection avant du module photovoltaïque, comme une plaque ou un panneau de verre, avec un élément de protection arrière du module photovoltaïque comme une feuille de protection aussi appelée feuille de protection arrière. La feuille de protection peut comporter un polymère fluoré comme un poly(fluorure de vinyle) - aussi nommé polyfluorure de vinyle - dont le sigle est PVF. Le PVF peut être du Tedlar^{®} tel que commercialisé par la société DuPont^{™}.

Une technique simple utilisée en vue de recycler un module photovoltaïque est de le broyer, puis de réaliser des traitements thermiques, ou chimiques, afin de séparer certains matériaux entrant dans sa composition, comme par exemple le verre, ou des métaux nobles comme l'argent ou le cuivre. Un inconvénient de cette technique est qu'elle est peu respectueuse de l'environnement. Par ailleurs, un autre inconvénient de cette technique est qu'elle est coûteuse en énergie. Encore un autre inconvénient de cette technique est que la montée en température du matériau de la feuille de protection arrière décrite peut provoquer des émanations importantes de polluants toxiques à partir du polymère fluoré. Encore un autre inconvénient de cette technique est qu'elle ne permet pas de récupérer intacts, ou majoritairement intacts, un ou plusieurs constituants du module photovoltaïque.

La demande de brevet CN103085116 propose d'utiliser un fil chauffant passant dans un matériau encapsulant des cellules photovoltaïques, ce matériau encapsulant étant de l'Ethylène Acétate de Vinyle. L'utilisation d'un fil chauffant présente les inconvénients suivants :
- l'apport de chaleur nécessaire engendre une consommation d'énergie thermique présentant un certain coût,
- le fil chauffant a de forts risques de rompre du fait de sa température, et des contraintes qu'il subit lors de son passage dans le matériau encapsulant,
- une telle utilisation n'est pas adaptée à un module photovoltaïque comportant une feuille de protection comprenant un polymère fluoré car la montée en température peut provoquer une émanation importante de gaz toxiques.

Le document « Production of Recyclable crystalline Si PV Modules » de M.A.A. Goris et al. publié en 2015 lors de la « 31 st European Photovoltaic Solar Energy Conférence and Exhibition », session 5 EO.1.2 p1925-1929, propose d'utiliser un fil de découpe combiné à un chauffage du module photovoltaïque pour séparer des cellules photovoltaïques par rapport à un panneau de verre du module photovoltaïque. Bien que le fil combiné à la montée en température du module photovoltaïque permette de faciliter la séparation de différents éléments du module photovoltaïque, une telle montée en température présente l'inconvénient d'engendrer une consommation d'énergie non négligeable. Un autre inconvénient de la solution décrite dans ce document est qu'elle n'est pas adaptée à un module photovoltaïque à élément de protection arrière comportant un polymère fluoré car il y aurait un risque de dégagement de gaz toxiques lors de son retrait du fait du chauffage du module photovoltaïque.

La demande de brevet FR3017551 propose de retirer par enroulement une feuille arrière d'un module photovoltaïque, ladite feuille arrière comportant du polyfluorure de vinyle. Le retrait est assisté par chauffage du module photovoltaïque. Le retrait proposé présente l'inconvénient de nécessiter un apport de chaleur conséquent au niveau du module photovoltaïque, ceci ayant un coût et pouvant entrainer un dégagement de gaz toxiques à partir du polyfluorure de vinyle.

Les documents JP 2009 214058 A, JP 2015 110201 A, EP 1 830 411 A1 et US 2010/197202 A1 se réfèrent à un procédé de désassemblage d'un module photovoltaïque comprenant des cellules solaires encapsulées entre deux plaques de protection, dans lequel le procédé comprend une étape de séparation des cellules solaires d'une des plaques de protection en coupant l'encapsulation entre les cellules solaires et cette plaque de protection par un fil. Dans le document JP 2009 214058 A, le fil est un fil abrasif.

### Objet de l'invention

L'invention tend à remédier au moins en partie aux inconvénients de l'art antérieur.

Pour cela, l'invention a pour objet un procédé de désassemblage d'un module photovoltaïque selon la revendication 1 comportant :
- un premier élément de protection,
- un deuxième élément de protection,
- des cellules photovoltaïques situées entre le premier élément de protection et le deuxième élément de protection,
- une enveloppe d'encapsulation des cellules photovoltaïques, ladite enveloppe reliant le premier élément de protection au deuxième élément de protection et comportant :
   ∘ une première partie située entre les cellules photovoltaïques et le premier élément de protection, et
   ∘ une deuxième partie située entre les cellules photovoltaïques et le deuxième élément de protection,
ledit procédé de désassemblage comportant une étape de séparation des cellules photovoltaïques par rapport au premier élément de protection, ce procédé de désassemblage étant caractérisé en ce que l'étape de séparation des cellules photovoltaïques par rapport au premier élément de protection comporte une étape de découpe de la première partie de l'enveloppe par un fil abrasif, qui est est réalisée à sec.

Le procédé de désassemblage peut comporter une ou plusieurs des caractéristiques suivantes :
- le procédé de désassemblage comporte une étape de séparation des cellules photovoltaïques par rapport au deuxième élément de protection, comportant une étape de découpe de la deuxième partie de l'enveloppe ;
- l'étape de découpe de la deuxième partie de l'enveloppe est mise en oeuvre par ledit fil abrasif ou par un fil abrasif additionnel ;
- le premier élément de protection comportant des rebords en contact avec des bords latéraux de la première partie de l'enveloppe, le procédé de désassemblage comporte une étape de retrait des rebords du premier élément de protection, l'étape de découpe de la première partie de l'enveloppe étant mise en oeuvre après l'étape de retrait des rebords ;
- l'étape de retrait des rebords comporte :
   - une étape de formation d'une entaille dans le module photovoltaïque depuis une face extérieure du premier élément de protection de sorte à délimiter un cadre comportant les rebords,
   - une étape de découpe pratiquée dans des faces latérales du module photovoltaïque jusqu'à l'entaille en vue de désolidariser le cadre du module photovoltaïque ;
- l'étape de formation de l'entaille et l'étape de découpe pratiquée dans les faces latérales du module photovoltaïque sont réalisées par un faisceau de particules énergétiques issu d'une tête de découpe ;
- au cours de l'étape de découpe pratiquée dans les faces latérales du module photovoltaïque, la tête de découpe est guidée en utilisant des données issues d'un système de guidage comportant un système de vision optique, ou un détecteur de matériau ;
- au cours de l'étape de découpe pratiquée dans les faces latérales du module photovoltaïque, une action est exercée sur le cadre par un organe de préhension de sorte à écarter ledit cadre par rapport aux cellules photovoltaïques ;
- l'étape de séparation des cellules photovoltaïques par rapport au premier élément de protection comporte une étape de sollicitation du premier élément de protection, ladite étape de sollicitation écartant progressivement, au cours de l'étape de découpe de ladite première partie de l'enveloppe, ledit premier élément de protection par rapport aux cellules photovoltaïques au fur et à mesure de la progression du fil abrasif dans la première partie de l'enveloppe ;
- le procédé de désassemblage comporte une étape de refroidissement du module photovoltaïque, et l'étape de découpe de la première partie de l'enveloppe par le fil abrasif est réalisée au cours de l'étape de refroidissement du module photovoltaïque ;
- l'un des premier et deuxième éléments de protection est maintenu à plat lors de la mise en oeuvre de l'étape de découpe de la première partie de l'enveloppe.

L'invention est aussi relative à une installation pour le désassemblage d'un module photovoltaïque selon la revendication 16, ledit module photovoltaïque comportant un premier élément de protection, un deuxième élément de protection, des cellules photovoltaïques situées entre le premier élément de protection et le deuxième élément de protection, une enveloppe d'encapsulation des cellules photovoltaïques, ladite enveloppe reliant le premier élément de protection au deuxième élément de protection et comportant :
- une première partie située entre les cellules photovoltaïques et le premier élément de protection, et
- une deuxième partie située entre les cellules photovoltaïques et le deuxième élément de protection,
ladite installation comportant un poste de découpe du module photovoltaïque comprenant un outil de découpe muni d'un fil, ladite installation étant caractérisée en ce que le fil est un fil abrasif agencé de sorte à permettre une découpe à sec, de la première partie de l'enveloppe en vue de séparer les cellules photovoltaïques par rapport au premier élément de protection.

### Description sommaire des dessins

D'autres avantages et caractéristiques ressortiront clairement de la description qui va suivre de modes particuliers de réalisation de l'invention donnés à titre d'exemples non limitatifs et représentés sur les dessins annexés, dans lesquels :
- La figure 1 illustre un module photovoltaïque selon un premier mode de réalisation ;
- La figure 2 illustre une vue en coupe transversale du module photovoltaïque de la figure 1 ;
- La figure 3 illustre un module photovoltaïque selon un deuxième mode de réalisation ;
- La figure 4 illustre une vue en coupe transversale du module photovoltaïque de la figure 3 ;
- La figure 5 illustre schématiquement des étapes d'un procédé de désassemblage du module photovoltaïque ;
- Les figures 6 et 7 illustrent respectivement selon une vue en perspective et selon une vue en coupe transversale de ladite vue en perspective, une étape de découpe par fil abrasif du module photovoltaïque selon son premier mode de réalisation ;
- La figure 8 illustre schématiquement une portion d'un fil abrasif ;
- Les figures 9 et 10 illustrent respectivement selon une vue en perspective et selon une vue en coupe transversale de ladite vue en perspective, des étapes de découpe par fil abrasif du module photovoltaïque selon son premier mode de réalisation ;
- Les figures 11 et 12 illustrent respectivement selon une vue en perspective et selon une vue en coupe transversale de ladite vue en perspective, des étapes de découpe par fils abrasifs du module photovoltaïque selon son premier mode de réalisation ;
- Les figures 13 et 14 illustrent respectivement selon une vue en perspective et selon une vue en coupe transversale de ladite vue en perspective, une étape de découpe par fil abrasif du module photovoltaïque selon son deuxième mode de réalisation ;
- Les figures 15 à 18 illustrent différentes réalisations, vues en perspective, d'une étape de retrait de rebords d'un premier élément de protection du module photovoltaïque ;
- Les figures 19 à 21 illustrent des vues en coupes transversales du module photovoltaïque selon son deuxième mode de réalisation dans un poste de découpe permettant de visualiser différentes réalisations d'étape(s) de découpe ;
- La figure 22 illustre, vue en perspective, une séparation par enroulement du premier élément de protection par rapport au reste du module photovoltaïque.

Dans ces figures, les mêmes références sont utilisées pour désigner les mêmes éléments.

Par ailleurs, les éléments représentés sur les figures ne sont pas nécessairement à l'échelle pour faciliter la compréhension des figures.

### Description de modes particuliers de réalisation

Dans la présente description, par « à base de » on entend « comporte au moins majoritairement ».

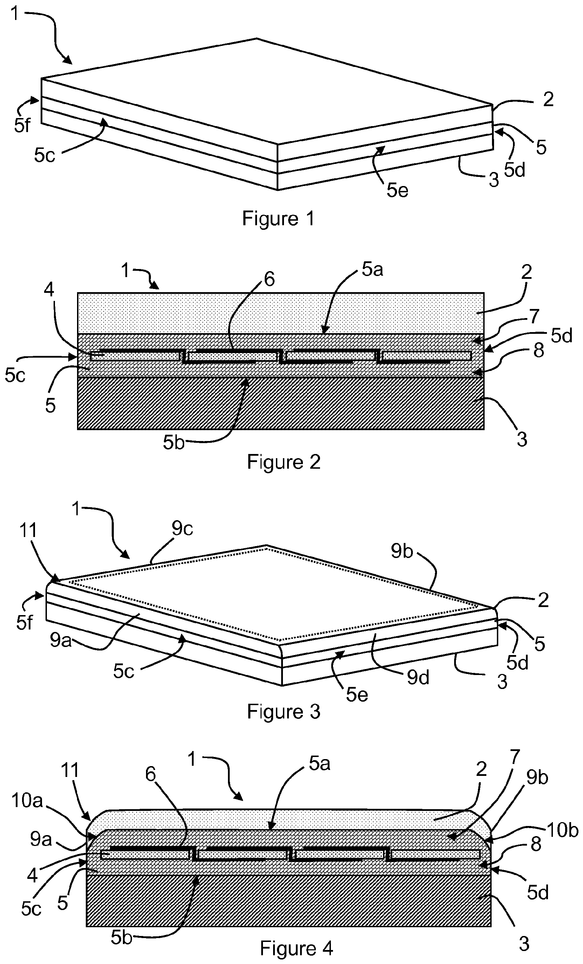

Les figures 1 à 4 illustrent deux modes de réalisation d'un module photovoltaïque 1 pouvant être utilisé dans le cadre du procédé de désassemblage et de l'installation de désassemblage décrits plus en détails ci-après. De manière générale, le module photovoltaïque 1 peut comporter un premier élément de protection 2, un deuxième élément de protection 3, des cellules photovoltaïques 4, et un ou des matériaux d'encapsulation formant une enveloppe 5 d'encapsulation des cellules photovoltaïques 4. Par la suite, l'enveloppe 5 représente l'enveloppe d'encapsulation des cellules photovoltaïques 4. Sur les figures 2 et 4, à titre d'exemple, quatre cellules photovoltaïques 4 sont visibles. Les cellules photovoltaïques 4 du module photovoltaïque 1 sont notamment agencées selon un même plan de sorte à former un squelette de cellules photovoltaïques 4 également connu sous le nom anglo-saxon de « string », notamment reliées électriquement en série par des connecteurs 6. Les cellules photovoltaïques 4 sont situées entre les premier et deuxième éléments de protection 2, 3. L'enveloppe 5 relie le premier élément de protection 2 au deuxième élément de protection 3. L'enveloppe 5 comporte une première partie 7 située entre les cellules photovoltaïques 4 et le premier élément de protection 2. L'enveloppe 5 comporte une deuxième partie 8 située entre les cellules photovoltaïques 4 et le deuxième élément de protection 3. L'enveloppe 5 permet, d'une part, de protéger les cellules photovoltaïques 4 de l'environnement extérieur en les encapsulant, et, d'autre part, d'assurer l'assemblage du premier élément de protection 2 au deuxième élément de protection 3, et donc d'assurer l'assemblage des cellules photovoltaïques 4 à ces premier et deuxième éléments de protection 2, 3. Ainsi, l'enveloppe 5 peut comporter (figures 2 et 4) une première face principale 5a et une deuxième face principale 5b fixées respectivement au premier élément de protection 2 et au deuxième élément de protection 3. La première face principale 5a est opposée à la deuxième face principale 5b. L'enveloppe 5 comporte aussi des bords latéraux 5c, 5d, 5e, 5f, notamment au nombre de quatre, reliant chacun la première face principale 5a à la deuxième face principale 5b. Lors de la fabrication du module photovoltaïque 1, il est possible de réaliser un empilement comportant successivement le premier élément de protection 2, au moins une feuille en un matériau destiné à encapsuler les cellules photovoltaïques 4 dit matériau d'encapsulation, les cellules photovoltaïques 4, de préférence au moins une autre feuille en un matériau destiné à encapsuler les cellules photovoltaïques 4 dit matériau d'encapsulation, puis le deuxième élément de protection 3. Ensuite, l'empilement est laminé à chaud de sorte que le ou les matériaux d'encapsulation fusionnent et forment l'enveloppe 5 d'où il résulte l'obtention de la structure évoquée ci-dessus du module photovoltaïque 1.

Par « élément de protection », on entend dans la présente description un élément pouvant présenter une fonction de rigidification et/ou une fonction de protection de surface. Notamment, l'un des premier et deuxième éléments de protection 2, 3 forme une face avant du module photovoltaïque 1, et l'autre des premier et deuxième éléments de protection 2, 3 forme une face arrière du module photovoltaïque 1 opposée à la face avant du module photovoltaïque 1. Ainsi, les premier et deuxième éléments de protection 2, 3 peuvent former des faces externes du module photovoltaïque 1. La face avant du module photovoltaïque 1 est destinée à être orientée pour recevoir le rayonnement solaire en vue de permettre la conversion d'énergie solaire en électricité par les cellules photovoltaïques 4 du module photovoltaïque 1. Par exemple, l'élément de protection correspondant peut, le cas échéant, présenter une protection contre les ultraviolets, une imperméabilité aux gaz et à l'eau. Par ailleurs, l'élément de protection peut, le cas échéant, servir de protection électrique (isolation électrique), de protection mécanique et de barrière à l'humidité.

Les figures 1 et 2 illustrent un premier mode de réalisation du module photovoltaïque 1 pour lequel les premier et deuxième éléments de protection 2, 3 laissent passer la lumière, ils peuvent être en verre. Les premier et deuxième éléments de protection 2, 3 peuvent être des couches, des plaques, ou des panneaux, notamment de verre ou à base de verre. Cette structure de module photovoltaïque 1 est aussi connue sous la dénomination bi-verre ou module bifacial. Les premier et deuxième éléments de protection 2, 3 peuvent ici assurer, notamment en plus de la transmission du rayonnement solaire, une fonction de rigidification et de protection contre les agressions extérieures, comme par exemple la grêle, une fonction d'imperméabilité aux gaz et à l'eau, une fonction de protection contre les ultraviolets et une fonction de protection électrique (isolation électrique).

Les figures 3 et 4 illustrent un deuxième mode de réalisation du module photovoltaïque 1. Dans ce cas là, il s'agit d'un module mono-facial, dont un seul des premier et deuxième éléments de protection 2, 3 laisse passer la lumière. Ici, le deuxième élément de protection 3, notamment en verre, laisse passer la lumière, il peut être une couche, une plaque, ou un panneau, notamment de verre ou à base de verre. Le deuxième élément de protection 3 forme la face avant du module photovoltaïque 1. Le premier élément de protection 2 forme quant à lui la face arrière du module photovoltaïque 1. Le premier élément de protection 2 est aussi appelé « backsheet » en langue anglaise.

En figures 3 et 4, le deuxième élément de protection 3 peut assurer, en plus de la transmission du rayonnement solaire, une fonction de rigidification et de protection contre les agressions extérieures, comme par exemple la grêle, une fonction d'imperméabilité aux gaz et à l'eau, une fonction de protection contre les ultraviolets et une fonction de protection électrique (isolation électrique). Le premier élément de protection 2 peut assurer ici une protection contre les variations de température, les atmosphères corrosives, l'humidité, le sel. Le premier élément de protection 2 peut aussi assurer une fonction d'imperméabilité aux gaz et à l'eau, une fonction de protection électrique (isolation électrique), et une fonction de protection mécanique. Le premier élément de protection 2 peut comporter un polymère fluoré, notamment un poly(fluorure de vinyle) (dont le sigle est PVF) par exemple tel que commercialisé par la société DuPont^{™} sous le nom de Tedlar^{®}. Notamment, le premier élément de protection 2 peut comporter un empilement des couches suivantes : une couche en PVF, une couche en poly(téréphtalate d'éthylène) (dont le sigle est PET), une couche en PVF. La couche en PET est agencée entre les couches en PVF. Notamment, les couches en PVF permettent de former une barrière à l'humidité, et la couche en PET permet de former une protection électrique (isolation électrique). Notamment, le premier élément de protection 2 peut adopter la forme d'une feuille comportant par exemple l'empilement des couches décrit précédemment. Le premier élément de protection 2 peut présenter une souplesse autorisant son enroulement sur lui-même lorsqu'il est séparé du module photovoltaïque 1.

Selon ce deuxième mode de réalisation du module photovoltaïque 1, le premier élément de protection 2 comporte des rebords 9a, 9b, 9c, 9d en contact avec l'enveloppe 5, notamment avec des bords dits latéraux 10a, 10b (figure 4) de la première partie 7 de l'enveloppe 5. Ces rebords 9a, 9b, 9c, 9d ainsi que les bords latéraux 10a, 10b de la première partie 7 de l'enveloppe 5 peuvent être au moins en partie arrondis du fait du laminage à chaud évoqué ci-dessus pour former le module photovoltaïque 1. En particulier, le premier élément de protection 2 comporte quatre rebords 9a, 9b, 9c, 9d chacun en contact avec un bord latéral 10a, 10b correspondant de la première partie 7 de l'enveloppe 5. Les rebords 9a, 9b, 9c, 9d forment un contour 11 (dont une limite est représentée par les pointillés en figure 3), ou une bordure, du premier élément de protection 2. La présence de ces rebords 9a, 9b, 9c, 9d est notamment la conséquence du laminage à chaud évoqué précédemment. Les bords latéraux 10a, 10b de la première partie 7 de l'enveloppe 5 sont des bords qui s'étendent depuis la première face principale 5a de l'enveloppe 5 en direction de la deuxième face principale 5b de l'enveloppe 5 : les bords latéraux 10a, 10b de la première partie 7 de l'enveloppe 5 forment une portion des bords latéraux de l'enveloppe 5.

De manière générale, l'enveloppe 5 peut comporter de l'éthylène acétate de vinyle (EVA sigle de « Ethylene-Vinyl Acétate » en langue anglaise), ou plus particulièrement être à base d'éthylène acétate de vinyle.

Notamment, la première partie 7 de l'enveloppe 5 et la deuxième partie 8 de l'enveloppe 5 peuvent présenter chacune une épaisseur comprise entre 100µm et 400µm, et notamment strictement à inférieure à 300µm ou à 200µm. L'épaisseur est ici mesurée respectivement entre les cellules photovoltaïques 4 et le premier élément de protection 2 pour la première partie 7 de l'enveloppe 5, et entre les cellules photovoltaïques 4 et le deuxième élément de protection 3 pour la deuxième partie 8 de l'enveloppe 5.

Classiquement, un module photovoltaïque peut aussi comporter un cadre de protection en aluminium ou autre matériau (non représenté) venant enserrer les faces opposées des premier et deuxième éléments de protection. Dans le procédé de désassemblage décrit ci-après, le module photovoltaïque ne comporte pas ce cadre de protection qui pourra avoir été retiré au préalable. Le module photovoltaïque peut aussi être associé à une boîte de jonction qui est aussi retirée avant de désassembler le module photovoltaïque selon le procédé de désassemblage décrit ci-après.

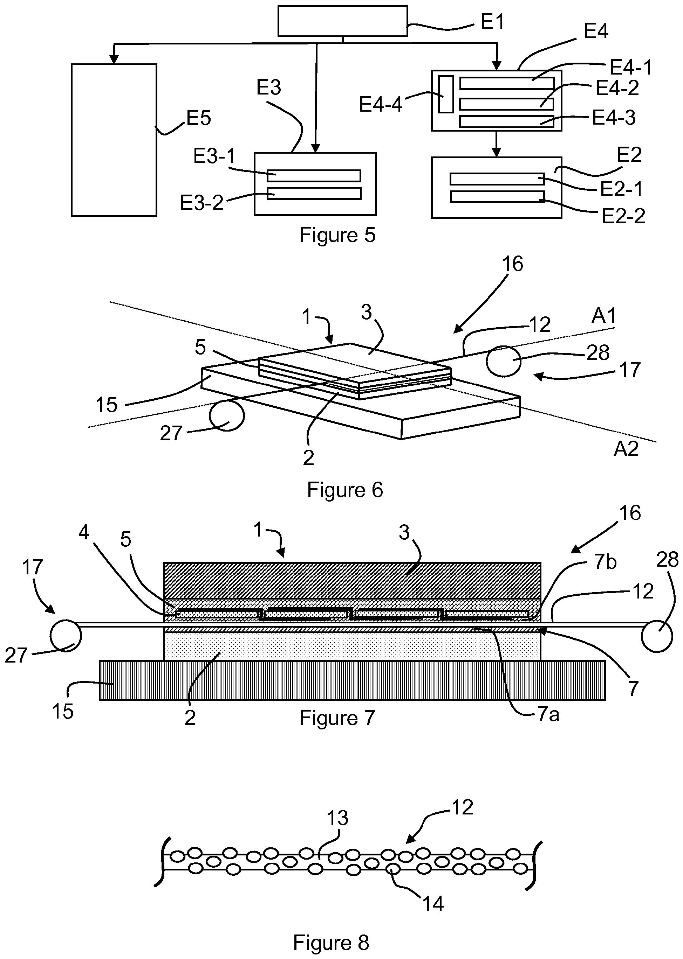

Comme illustré à titre d'exemple en figures 5 à 7, le procédé de désassemblage du module photovoltaïque 1 comporte avantageusement une étape E1 de fourniture du module photovoltaïque 1 tel que décrit précédemment. Le cas échéant, il est entendu que toutes les étapes mises en oeuvre au cours du procédé de désassemblage le sont à partir du module photovoltaïque 1 fourni. Par ailleurs, un tel procédé de désassemblage comporte une étape de séparation E2 des cellules photovoltaïques 4 par rapport au premier élément de protection 2. L'étape de séparation E2 comporte une étape de découpe E2-1 de la première partie 7 de l'enveloppe 5 par un fil abrasif 12. L'étape de séparation E2 est notamment telle qu'au terme de l'étape de découpe E2-1 de la première partie 7 de l'enveloppe 5, les cellules photovoltaïques 4, liées au premier élément de protection 2 par la première partie 7 de l'enveloppe 5 avant l'étape de séparation E2, sont séparées (c'est-à-dire désassemblées) du premier élément de protection 2. En fait, l'étape de découpe E2-1 par le fil abrasif 12 met en oeuvre des allers-retours du fil abrasif 12 selon son axe longitudinal A1, et un déplacement relatif entre le fil abrasif 12 et le module photovoltaïque 1 (selon l'axe A2 de préférence orthogonal à, ou formant un angle non nul avec, l'axe A1).

L'étape de découpe E2-1 utilisant le fil abrasif 12 réalise un sciage de la première partie 7 de l'enveloppe 5 entre le premier élément de protection 2 et les cellules photovoltaïques 4. L'utilisation du fil abrasif 12 pour la découpe présente l'avantage de limiter la montée en température du module photovoltaïque 1, du fait du sciage, à l'endroit où la découpe est réalisée contrairement à un couplage d'un simple fil à un système de chauffe impliquant une montée en température plus importante. Par ailleurs, l'utilisation du fil abrasif 12 limite le risque de recollage du matériau de l'enveloppe 5 sur lui-même au cours du passage du fil abrasif 12 dans la première partie 7 de l'enveloppe 5. Par ailleurs, le risque de casse d'un tel fil abrasif 12 est moins important que celui d'un fil chauffant, en particulier du fait que le fil abrasif 12 peut être renouvelé au fur et à mesure des allers-retours par un apport de fil neuf comme il le sera vu par la suite. En outre, avec le fil abrasif 12, il n'y a pas besoin de monter la température du module photovoltaïque 1 pour réaliser la découpe. Le fil abrasif 12, tel qu'illustré en figure 8, comporte un fil de support 13, aussi appelé âme centrale, sur lequel sont fixées des particules abrasives 14 représentées schématiquement par des éléments ovales en figure 8. Le fil de support 13 peut être, par exemple, en acier. Selon une autre formulation, le fil abrasif 12 est formé de particules abrasives maintenues sur l'âme centrale du fil abrasif 12 par un liant. Dans le cadre du fil abrasif 12, les particules abrasives sont préférentiellement en diamant, autrement dit, le fil abrasif 12 peut être un fil diamanté. Sur les figures 6 et 7, il est représenté à titre d'exemple le module photovoltaïque 1 selon le premier mode de réalisation du module photovoltaïque dont le premier élément de protection 2 est en contact avec un support 15, bien entendu il peut aussi être utilisé le module photovoltaïque selon son deuxième mode de réalisation, notamment dont le deuxième élément de protection sera en contact avec le support comme cela sera décrit ci-après.

Un fil abrasif, notamment diamanté, est en général utilisé pour découper des matériaux durs comme le saphir, le carbure de silicium (SiC), le nitrure de silicium (Si₃N₄), le silicium (Si). Les matériaux durs sont, par nature, fragiles et cassants. En ce sens, les particules abrasives du fil abrasif pénètrent le matériau à découper de sorte que les particules abrasives du fil abrasif arrachent des copeaux de matière par phénomène d'écaillage ou d'indentation. Par ailleurs, l'utilisation classique du fil abrasif nécessite la présence d'un liquide de coupe au niveau du contact entre le fil abrasif et le matériau à découper. Le liquide de coupe est un liquide de refroidissement et un lubrifiant permettant l'élimination des copeaux et le nettoyage du fil abrasif. Par ailleurs, le liquide de coupe peut aussi être un antioxydant.

Le matériau à découper dans le cadre du module photovoltaïque 1 est un matériau d'encapsulation formant l'enveloppe 5 : il ne présente pas les caractéristiques usuelles des matériaux généralement découpés par fil abrasif, en particulier diamanté. Ce matériau à découper peut comporter de l'EVA, ou être à base d'EVA. De manière surprenante, le ou les matériaux de l'enveloppe 5, bien que ne présentant pas les caractéristiques usuelles de dureté des matériaux découpés par un fil abrasif (l'EVA présente une dureté strictement inférieure à celle du silicium ou du SiC), peuvent être découpés par le fil abrasif 12 de manière efficace, notamment sans apport extérieur de chaleur.

De manière encore plus surprenante, la découpe de la première partie 7 de l'enveloppe 5 par le fil abrasif 12 sans utilisation de liquide de coupe procure de meilleurs résultats qu'avec l'utilisation du liquide de coupe. En effet, il a été constaté que l'ajout du liquide de coupe fait augmenter la flèche du (c'est-à-dire l'amplitude de déformation du) fil abrasif 12 lors de la découpe de la première partie 7 de l'enveloppe 5, ceci pouvant entraîner la casse du fil abrasif 12 du fait de contraintes importantes subies par le fil abrasif 12. Sans liquide de coupe, et dans des conditions similaires de découpe à celles de la découpe avec liquide de coupe, la flèche du fil abrasif 12 reste stable dans le temps, ce qui signifie que le fil abrasif 12 découpe la première partie 7 de l'enveloppe 5 de façon régulière. Autrement dit, l'étape de découpe E2-1 de la première partie 7 de l'enveloppe 5 par le fil abrasif 12 peut être réalisée à sec (c'est-à-dire sans liquide de coupe).

Néanmoins, il est possible d'utiliser un fluide de refroidissement pour réaliser une lubrification intermittente afin de refroidir la première partie 7 de l'enveloppe 5 au contact avec le fil abrasif 12. En effet, la première partie 7 de l'enveloppe 5 s'échauffe ponctuellement au passage du fil abrasif 12. Aux abords de certains matériaux conducteurs de chaleur, tel que des bandes de cuivre formant par exemple les connecteurs évoqués précédemment, une légère lubrification permet de limiter la formation d'étincelles. Par légère lubrification, on entend une lubrification selon un goutte à goutte, par exemple une goutte par seconde, la lubrification pouvant être réalisée par de l'eau, ou de l'eau avec des additifs, pour nettoyer et refroidir le fil abrasif.

L'invention est aussi relative à une installation de désassemblage du module photovoltaïque 1 tel que décrit. Au moins une partie de l'installation est illustrée schématiquement en figures 6 et 7. Une telle installation comporte un poste de découpe 16 du module photovoltaïque 1 comprenant un outil de découpe 17 muni du fil abrasif 12 agencé de sorte à permettre la découpe à sec, de la première partie 7 de l'enveloppe 5 en vue de séparer les cellules photovoltaïques 4 par rapport au premier élément de protection 2. L'installation peut aussi comporter le support 15 sur lequel est positionné le module photovoltaïque 1 au cours de l'étape de séparation E2. Au sein du poste de découpe 16, la hauteur du fil abrasif 12 par rapport au support 15 est calculée de sorte à permettre la découpe souhaitée de la première partie 7 de l'enveloppe 5 lorsque, le cas échéant, le premier élément de protection ou le deuxième élément de protection repose sur le support 15. Dans le poste de découpe 16, le support 15 peut se déplacer alors que l'outil de découpe 17 reste fixe, nonobstant le défilement du fil abrasif 12 pour permettre la découpe. Alternativement, c'est l'outil de découpe 17 qui se déplace dans le poste de découpe 16 alors que le module photovoltaïque 1 reste fixe dans le poste de découpe 16. Ainsi, l'installation peut être configurée pour mettre en oeuvre un mouvement relatif entre le support 15 et l'outil de découpe 17 lors de la découpe de la première partie 7 de l'enveloppe 5. Les avantages liés à une telle installation de désassemblage découlent de ceux liés au procédé de désassemblage.

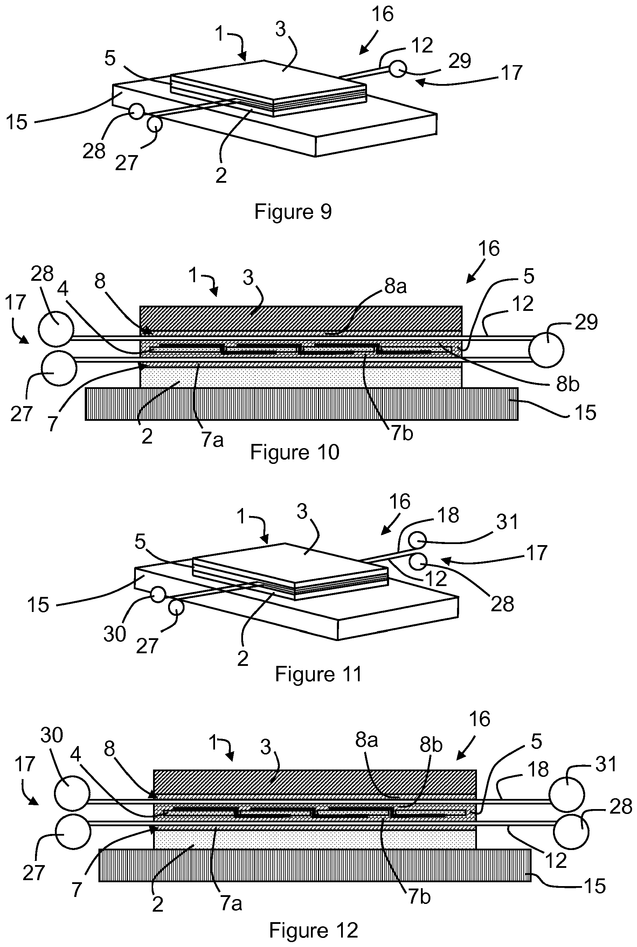

Selon une réalisation, le procédé de désassemblage peut aussi comporter une étape de séparation E3 des cellules photovoltaïques 4 par rapport au deuxième élément de protection 3. Ladite étape de séparation E3 comporte une étape de découpe E3-1 (figures 5, et 9 à 12) de la deuxième partie 8 de l'enveloppe 5. L'étape de séparation E3 est notamment telle qu'au terme de l'étape de découpe E3-1 les cellules photovoltaïques 4, liées au deuxième élément de protection 3 par la deuxième partie 8 de l'enveloppe 5 avant l'étape de séparation E3, sont séparées (désassemblées) du deuxième élément de protection 3. Cette étape de découpe E3-1 de la deuxième partie 8 de l'enveloppe 5 peut être mise en oeuvre par ledit fil abrasif 12 (figures 9 et 10), ou par un fil abrasif additionnel 18 (figure 11 et 12). Ainsi, il est avantageusement possible de séparer le module photovoltaïque 1 en au moins trois parties comportant respectivement le premier élément de protection 2, les cellules photovoltaïques 4 et le deuxième élément de protection 3 qui pourront alors être recyclés chacun indépendamment, au contraire du broyage selon l'art antérieur.

Sur les figures 9 et 10, l'outil de découpe 17 du poste de découpe 16 comporte un seul fil abrasif 12 réalisant la découpe des première et deuxième parties 7, 8 de l'enveloppe 5, notamment de manière simultanée. Sur les figures 11 et 12, l'outil de découpe 17 du poste de découpe 16 comporte deux fils abrasifs 12, 18 distincts, l'un des deux fils abrasifs 12 réalisant la découpe de la première partie 7 de l'enveloppe 5, et l'autre des deux fils abrasifs 18 réalisant la découpe de la deuxième partie 8 de l'enveloppe 5.

Ce qui s'applique au fil abrasif 12 peut aussi s'appliquer au fil abrasif additionnel 18. Les étapes de découpe E2-1 et E3-1 sont réalisées à sec. L'utilisation d'un même fil abrasif 12 pour réaliser les étapes de découpe E2-1 et E3-1 est préférée pour limiter les coûts liés à l'utilisation de deux fils abrasifs. Tout ce qui peut s'appliquer à la découpe de la première partie 7 de l'enveloppe 5 par le fil abrasif 12 peut aussi s'appliquer à la découpe de la deuxième partie 8 de l'enveloppe 5 par un fil abrasif additionnel ou non. L'utilisation de deux fils abrasifs n'est pas préférée car elle complexifie l'outil de découpe 17, et augmente donc le coût de l'outil de découpe 17. L'utilisation de deux fils abrasifs peut présenter un intérêt si les première et deuxième parties 7, 8 de l'enveloppe 5 sont dans des matériaux différents. De préférence, les première et deuxième parties 7, 8 de l'enveloppe 5 sont dans un même matériau, on préfère donc l'utilisation d'un seul fil abrasif 12 pour réaliser les étapes de découpe E2-1 et E3-1.

Comme illustré en figures 9 à 12, le module photovoltaïque 1, selon le premier mode de réalisation du module photovoltaïque, permet de dissocier le cas échéant deux panneaux (notamment de verre ou à base de verre), formant respectivement les premier et deuxième éléments de protection 2, 3, par rapport aux cellules photovoltaïques 4.

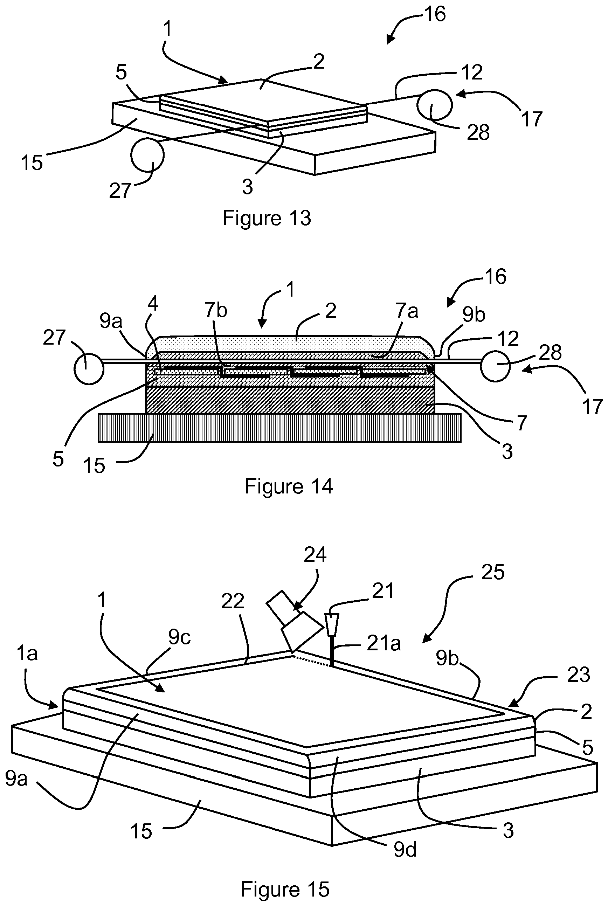

Les figures 13 et 14 illustrent l'étape de découpe E2-1 de la première partie 7 de l'enveloppe 5 décrite ci-avant dans le cas du module photovoltaïque 1 selon son deuxième mode de réalisation. On comprend que les rebords 9a, 9b (figure 14) du premier élément de protection 2 vont se trouver sur le passage du fil abrasif 12 lors de la découpe correspondante puisque le fil abrasif 12 réalise une découpe selon un plan horizontal. En ce sens, le fil abrasif 12 ne peut pas contourner les rebords 9a, 9b, 9c, 9d (figure 3) ceci pouvant rendre la découpe plus difficile, voire pouvant entrainer la casse du fil abrasif 12. En figures 13 et 14, le deuxième élément de protection 3 repose sur le support 15.

Ainsi, selon une réalisation particulière, le procédé de désassemblage peut comporter une étape de retrait E4 (figure 5) des rebords 9a, 9b, 9c, 9d du premier élément de protection 2, ceci permettant de faciliter le passage du fil abrasif 12 au travers du module photovoltaïque 1 dans la première partie 7 de l'enveloppe 5. Consécutivement à l'étape de retrait E4, on dit que l'enveloppe 5 présente des bords latéraux libres, notamment par lesquels le fil abrasif peut passer. L'étape de découpe E2-1 de la première partie 7 de l'enveloppe 5, et plus généralement l'étape de séparation E2, est mise en oeuvre après l'étape de retrait E4. Ainsi, ledit fil abrasif 12 peut passer par les bords latéraux, aussi appelés bords latéraux libérés, de la première partie 7 de l'enveloppe 5 éventuellement tels qu'ils ont pu être modifiés par l'étape de retrait E4. Il en résulte que le premier élément de protection 2 est modifié avant l'étape de découpe E2-1 de la première partie 7 de l'enveloppe 5 de telle sorte que ce dernier n'entrave pas la découpe. Ainsi, lors de l'étape de découpe E2-1, le fil abrasif 12 reste à distance du premier élément de protection 2. On comprend alors qu'il existe un besoin de développer une solution efficace permettant de mettre en oeuvre ce retrait.

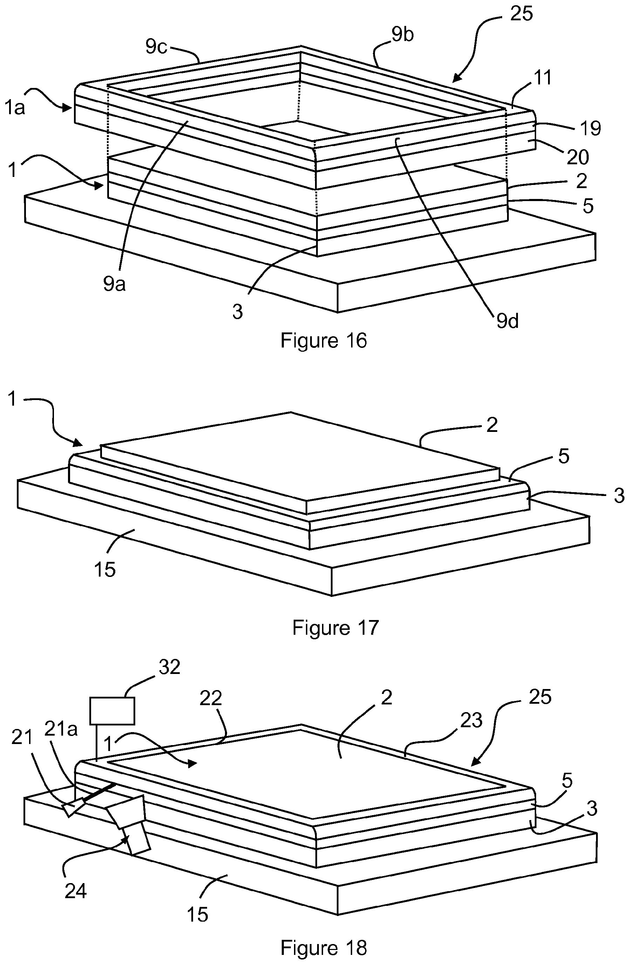

Selon une première réalisation de l'étape de retrait E4 des rebords 9a, 9b, 9c, 9d, il peut être retiré tout un bord périphérique 1a du module photovoltaïque 1 (figures 15 et 16), ledit bord périphérique 1a comprenant le contour 11 du premier élément de protection 2, un bord périphérique 19 de l'enveloppe 5, et un bord périphérique 20 du deuxième élément de protection 3. Cette première réalisation de l'étape de retrait E4 peut être mise en oeuvre par découpe en utilisant, c'est-à-dire par, un faisceau 21a de particules énergétiques issu d'une tête de découpe 21 formant une entaille 22 selon toute l'épaisseur du module photovoltaïque 1 en suivant les pointillés indiqués en figures 3 et 15 sur une face libre du premier élément de protection 2 (notamment la face arrière du module photovoltaïque 1). Cette première réalisation de l'étape de retrait E4 présente l'inconvénient que les matériaux contenus dans le bord périphérique 1a du module photovoltaïque 1 tel que retiré ne seront pas ou difficilement recyclables, par ailleurs il y a aussi un risque de casser la partie restante du deuxième élément de protection 3 qui peut être un panneau, notamment de verre ou à base de verre, qui ne pourra plus être réutilisé en l'état.

Dans la présente description, un faisceau de particules énergétiques issu d'une tête de découpe peut découper le module photovoltaïque, notamment le matériau de l'enveloppe 5. Le faisceau de particules énergétiques est concentré pour permettre un enlèvement de matière correspondant. Selon une réalisation, le faisceau 21a de particules énergétiques est un faisceau laser, les particules énergétiques sont des photons. Le faisceau laser peut être assisté par un jet d'eau dont le rôle est de guider le faisceau laser pour que celui-ci soit cylindrique et non conique. Selon une autre réalisation, le faisceau 21a de particules énergétiques est un jet d'eau abrasif, les particules du faisceau comportent alors des particules (aussi appelées molécules) d'eau et des particules abrasives (notamment en SiC, en corindon par exemple naturel, ou formées par du sable de grenat). De préférence, les particules abrasives du jet d'eau présentent une grande dureté (Mohs supérieur à 8) et une granulométrie permettant de s'adapter au besoin de l'étape de retrait E4. Ces particules abrasives du jet d'eau sont propulsées par les particules d'eau contenues dans le jet d'eau abrasif de sorte que les particules abrasives du jet d'eau présentent une énergie cinétique suffisante pour réaliser un enlèvement de matière souhaité. Lorsque le faisceau 21a est un jet d'eau abrasif, la pression du jet d'eau abrasif peut être comprise entre 1000 bars et 6000 bars. La quantité de particules abrasives utilisées dans le jet d'eau abrasif peut être adaptée selon les besoins. Le jet d'eau abrasif en tant que faisceau 10 présente l'avantage de ne pas apporter d'échauffement, l'avantage de limiter la consommation énergétique, et est plus simple à mettre en oeuvre. Les avantages du faisceau laser sont qu'il est plus précis car il présente un trait de coupe plus fin, et qu'il n'implique pas de retraiter du liquide souillé.

Selon une deuxième réalisation de l'étape de retrait E4 des rebords, ces derniers peuvent être retirés par usinage mécanique, par exemple en utilisant une fraise de défonceuse d'où il résulte qu'en enlevant les rebords 9a, 9b, 9c, 9d de la figure 3 on obtient le résultat de la figure 17 où le premier élément de protection 2 du module photovoltaïque 1 est dépourvu de ses rebords initialement présents, et forme un épaulement avec l'enveloppe 5. Cette réalisation est simple à mettre en oeuvre, mais génère de la poussière polluante lorsque le premier élément de protection 2 comporte un polymère fluoré.

Selon une troisième réalisation de l'étape de retrait E4 des rebords 9a, 9b, 9c, 9d, l'étape de retrait E4 comporte (figures 5 et 15) une étape de formation E4-1 d'une entaille 22 dans le module photovoltaïque 1 depuis une face extérieure du premier élément de protection 2 de sorte à délimiter un cadre 23 comportant les rebords 9a, 9b, 9c, 9d. En figure 15, le deuxième élément de protection 3 est en contact avec le support 15. La face extérieure du premier élément de protection 2 est notamment orientée vers une direction opposée aux cellules photovoltaïques 4. La face extérieure est notamment la face arrière du module photovoltaïque 1. Ensuite, l'étape de retrait E4 comporte une étape de découpe E4-2 (figure 18) pratiquée dans les faces latérales du module photovoltaïque 1 jusqu'à l'entaille 22 en vue de désolidariser le cadre 23 du module photovoltaïque 1 d'où il résulte l'obtention du module photovoltaïque 1 selon la figure 17 notamment dont le deuxième élément de protection 3 est fixé au support 15. Selon une autre formulation, l'étape de retrait E4 comporte une étape de découpe E4-2 pratiquée dans les faces latérales du module photovoltaïque 1 jusqu'à l'entaille 22 en vue de désolidariser le cadre 23 par rapport au reste du module photovoltaïque 1, notamment par rapport à l'enveloppe 5 c'est-à-dire par rapport aux cellules photovoltaïques 4. Après l'étape de découpe E4-2, l'étape de retrait E4 peut comporter une étape d'enlèvement E4-3 du cadre 23.

Cette troisième réalisation de l'étape de retrait E4 permet de limiter la génération de poussières polluantes, et d'optimiser le recyclage du module photovoltaïque 1. L'étape de formation E4-1 de l'entaille 22 et l'étape de découpe E4-2 pratiquée dans les faces latérales du module photovoltaïque 1 peuvent être réalisées par un faisceau 21a de particules énergétiques issu d'une tête de découpe 21 tel que décrit précédemment (figures 15 et 18). La tête de découpe 21 est mobile par rapport au module photovoltaïque 1. Le faisceau 21a est calibré pour découper selon une profondeur désirée de l'entaille 22 et/ou selon une distance adaptée depuis les faces latérales du module photovoltaïque 1. L'utilisation d'une telle tête de découpe 21 permet de limiter la montée en température du premier élément de protection 2 lors du retrait des rebords 9a, 9b, 9c, 9d, ceci permettant de limiter l'émission de polluants lorsque le premier élément de protection 2 comporte un polymère fluoré. Le diamètre, ou dimension transversale maximale, du faisceau de particules énergétiques peut être compris entre 50µm et 300µm, ou par exemple entre 20µm et 100µm, ou peut être égal à 100µm, pour les dimensions données ci-avant d'épaisseur de la première partie 7 de l'enveloppe 5 de sorte à préférentiellement découper uniquement dans l'enveloppe 5 au cours de l'étape de découpe E4-2. Notamment, le cadre 23 est tel qu'il présente une largeur d'un centimètre prise dans le plan du premier élément de protection 2. La tête de découpe 21 peut être automatisée, et apte à se déplacer selon une pluralité de degrés de liberté, autorisant par exemple la tête de découpe 21 à se déplacer selon trois axes orthogonaux, et d'effectuer si besoin des rotations autour de ces axes orthogonaux. En particulier, la tête de découpe 21 peut être portée par un bras articulé. Selon une réalisation il est possible d'utiliser plusieurs faisceaux de particules énergétiques chacun issu d'une tête de découpe correspondante pour former l'entaille 22 et mettre en oeuvre l'étape de découpe E4-2.

De préférence, l'étape de découpe E4-2 pratiquée dans les faces latérales du module photovoltaïque 1 est réalisée dans l'enveloppe 5 à, c'est à dire au plus proche de, l'interface entre l'enveloppe 5 et le premier élément de protection 2. Il en résulte que le fond de l'entaille 22 est situé dans l'enveloppe 5. Ceci présente l'avantage d'éviter la présence de résidus issus des rebords 9a, 9b, 9c, 9d retirés sur l'enveloppe 5 une fois le cadre 23 retiré.

L'étape de découpe E4-2 peut être calibrée selon le type de module photovoltaïque 1 de sorte que la tête de découpe 21 adopte toujours la même trajectoire au cours de la découpe, ceci est possible si les formes et dimensions du module photovoltaïque 1 sont connues. Cependant, dans certains cas, le module photovoltaïque 1 peut être déformé, ou adopter une forme non connue. Il existe donc un besoin de guider la tête de découpe 21.

En ce sens, au cours de l'étape de découpe E4-2 pratiquée dans les faces latérales du module photovoltaïque 1, la tête de découpe 21 peut être guidée en utilisant des données issues d'un système de guidage 24 (figure 18) comprenant par exemple un système de vision optique, ou un détecteur de matériau. Le système de vision optique peut être du type à caméra, et est capable de déterminer où le faisceau 21a de particules énergétiques de la tête de découpe 21 coopère avec le module photovoltaïque 1 pour ajuster la trajectoire de la tête de découpe 21. Le détecteur de matériau peut comporter un duromètre utilisé pour détecter si le matériau découpé par la tête de découpe est le bon, ou détecter où orienter le faisceau, et ajuster la trajectoire de la tête de découpe 21 si nécessaire pour réaliser la découpe dans l'enveloppe 5 au plus proche du premier élément de protection 2. Alternativement, le détecteur de matériau peut mettre en oeuvre une spectroscopie sur plasma induit par laser (aussi connue sous le sigle LIBS pour « Laser-induced Breakdown Spectroscopie » en langue anglaise). Le duromètre présente l'avantage de fonctionner par contact, et permet donc de simplifier la détection de matériau(x). Le détecteur de type LIBS permet un asservissement indexé à une composition chimique, ceci sera plus coûteux à mettre en oeuvre, mais beaucoup plus précis que le duromètre. Le guidage de la tête de découpe 21 est avantageux pour que la découpe soit la plus propre possible en limitant la présence de résidus issus des rebords 9a, 9b, 9c, 9d du premier élément de protection 2 sur l'enveloppe 5. Le système de guidage 24 peut aussi être utilisé pour former l'entaille 22 (figure 15) dans le sens où il détecte lorsque le matériau de l'enveloppe 5 est atteint avant de déplacer la tête de découpe 21 au cours de la formation de l'entaille 22. Le guidage de la tête de découpe 21 est représenté schématiquement par l'étape E4-4 de la figure 5.

Au cours de l'étape de découpe E4-2, le cadre 23 peut être sollicité de sorte à l'écarter des cellules photovoltaïques 1. Ceci permet de faciliter le travail de la tête de découpe 21, et notamment éviter au cadre 23 de se recoller au matériau de l'enveloppe 5 en cas d'utilisation d'un laser venant chauffer localement où la découpe doit être réalisée. Autrement dit, au cours de l'étape de découpe E4-2 pratiquée dans les faces latérales du module photovoltaïque 1, une action sur le cadre 23 peut être exercée par un organe de préhension de sorte à écarter ledit cadre 23 par rapport aux cellules photovoltaïques 4.

L'installation de désassemblage peut comporter un poste de modification 25 du module photovoltaïque 1 (figures 15, 16, 18) avant son entrée dans le poste de découpe 16. Le poste de modification 25 peut comporter les moyens nécessaires au retrait des rebords 9a, 9b, 9c, 9d, notamment la tête de découpe 21 apte à se déplacer pour permettre une découpe du module photovoltaïque 1 en vue de retirer les rebords 9a, 9b, 9c, 9d évoqués précédemment, et le cas échéant l'organe de préhension 32 (figure 18) permettant de mettre en oeuvre l'action sur le cadre 23.

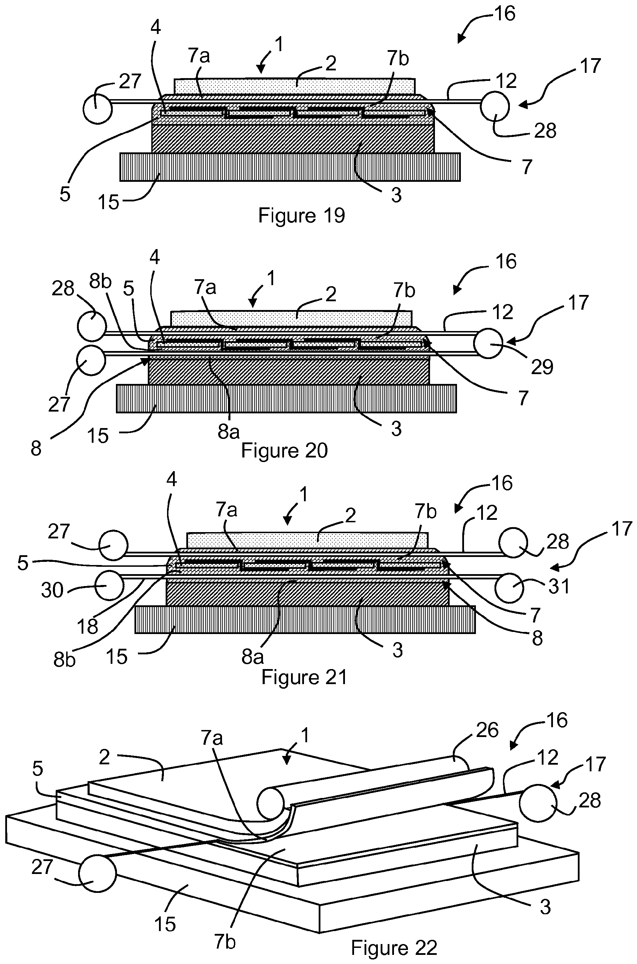

Après l'étape de retrait E4 des rebords 9a, 9b, 9c, 9d, il peut être mis en oeuvre l'étape de découpe E2-1 et/ou l'étape de découpe E3-1 telles que décrites ci-avant à partir du module photovoltaïque 1 dépourvu des rebords 9a, 9b, 9c, 9d comme illustré en figure 19 à 22. Les figures 19 à 21 illustrent l'étape de découpe E2-1 de la première partie 7 de l'enveloppe 5 avec le fil abrasif 12. La figure 20 montre la découpe de la deuxième partie 8 de l'enveloppe 5 avec le fil abrasif 12, et la figure 21 montre la découpe de la deuxième partie 8 de l'enveloppe 5 avec le fil abrasif additionnel 18.

Ainsi, pour que l'étape de découpe E2-1 et/ou l'étape de découpe E3-1 soient efficaces, le ou les fils abrasifs utilisés découpent préférentiellement, que dans l'enveloppe 5, le cas échéant dans la première partie 7 de l'enveloppe 5 et/ou dans la deuxième partie 8 de l'enveloppe 5.

De manière générale, le procédé de désassemblage peut comporter une étape de refroidissement E5 (figure 5) du module photovoltaïque 1. Notamment, l'étape de découpe E2-1 et/ou l'étape de découpe E3-1 et/ou l'étape de retrait E4 des rebords sont réalisées alors que le module photovoltaïque 1 est refroidi, c'est-à-dire au cours de l'étape de refroidissement E5. Ce refroidissement permet de rendre plus dure l'enveloppe 5 pour faciliter sa découpe, par exemple à l'aide d'un ou plusieurs fils abrasifs. Le refroidissement peut être mis en oeuvre par un groupe froid, par effet Peltier ou autre système permettant d'obtenir le résultat recherché. Par ailleurs, le refroidissement permet aussi d'éviter que les parties découpées ne se recollent après le passage du ou des fils abrasifs, ou le cas échéant du faisceau de particules énergétiques. Ainsi, l'étape de refroidissement E5 peut être telle qu'elle assure le maintien de la température du module photovoltaïque 1 entre -100°C et 10°C.

Alternativement, ou en combinaison au refroidissement, tout type de moyen permettant d'éviter, au cours du passage du fil abrasif 12, que les éléments à séparer du module photovoltaïque 1 ne se recollent peuvent être utilisés. Par exemple, de tels moyens peuvent comporter un injecteur d'air comprimé ou encore un dispositif d'écartement tendant à écarter les éléments du module photovoltaïque 1 à séparer. Ainsi, l'étape de séparation E2 peut comporter une étape de sollicitation E2-2 (figures 5 et 22) du premier élément de protection 2 par un dispositif d'écartement 26 de sorte à écarter progressivement ledit premier élément de protection 2 par rapport aux cellules photovoltaïques 4 au fur et à mesure de la progression du fil abrasif 12 dans la première partie 7 de l'enveloppe 5 au cours de l'étape de découpe E2-1 de ladite première partie 7 de l'enveloppe 5. Selon une autre formulation, l'étape de séparation E2 peut comporter une étape de sollicitation E2-2 (figures 5 et 22) du premier élément de protection 2, par exemple par un dispositif d'écartement 26, ladite étape de sollicitation E2-2 écartant progressivement, au cours de l'étape de découpe E2-1 de ladite première partie 7 de l'enveloppe 5, ledit premier élément de protection 2 par rapport aux cellules photovoltaïques 4 au fur et à mesure de la progression du fil abrasif 12 dans la première partie 7 de l'enveloppe 5. Un cylindre muni d'une pince de préhension peut former le dispositif d'écartement 26 sur lequel le premier élément de protection 2 vient s'enrouler. Ici, le cylindre est apte à effectuer un mouvement de rotation sur lui-même et un mouvement de translation orthogonalement à la direction de coupe par le fil abrasif 12 pour permettre l'enroulement adéquat du premier élément de protection 2. Le même principe peut s'appliquer au cours de l'étape de découpe E3 dans le sens où les cellules photovoltaïques 4 peuvent être écartées (étape E3-2 visible en figure 5) du deuxième élément de protection 3 pour éviter de recoller des portions découpées de la deuxième partie de l'enveloppe.

L'un des premier et deuxième élément de protection 2, 3, est, de préférence, maintenu à plat lors de la mise en oeuvre de l'étape de découpe E2-1 et/ou de l'étape de découpe E3-1. Pour mettre en oeuvre ce maintien, le support 15 visé précédemment peut comporter un adhésif, un système d'aspiration sous vide, ou encore un système de maintien mécanique permettant de plaquer, le cas échéant, le premier élément de protection 2 (figures 6, 7, 9 à 12) ou le deuxième élément de protection 3 (figures 19 à 22), contre le support 15 d'où il résulte qu'un éventuel voilage du module photovoltaïque 1 sera rattrapé. La mise à plat de l'un des premier et deuxième éléments de protection 2, 3 permet de faciliter la découpe par le ou les fils abrasifs pour s'assurer que cette découpe ne se fasse que dans le matériau de l'enveloppe 5 en tendant à mettre à plat les première et deuxième parties 7, 8 à découper de l'enveloppe 5. Ainsi, dans le cadre de l'installation, elle peut comporter le support 15 configuré pour maintenir l'un des premier et deuxième éléments de protection 2, 3 lors d'une découpe de la première partie 7 de l'enveloppe 5 par le fil abrasif 12 de l'outil de découpe 17, ceci s'appliquant aussi le cas échéant à l'étape E3-1.

De manière préférée, le premier élément de protection 2, ou le deuxième élément de protection 3, placé contre le support 15 est un panneau, notamment de verre ou à base de verre. L'avantage est que le panneau est plan et lisse, facilitant ainsi une mise à hauteur adaptée du ou des fils abrasifs pour réaliser la découpe selon l'étape de découpe E2-1 et/ou l'étape de découpe E3-1. Selon le deuxième mode de réalisation du module photovoltaïque 1, le deuxième élément de protection 3 est placé contre le support 15 pour la raison évoquée ci-dessus, et du fait que le premier élément de protection 2 présente une souplesse telle qu'il s'est modelé lors du laminage évoqué précédemment : ce premier élément de protection 2 n'est donc pas forcément plat.

De manière applicable à tout ce qui a été décrit précédemment, l'étape de découpe E2-1 est telle qu'à son terme une première portion 7a de la première partie 7 de l'enveloppe 5 reste solidaire du premier élément de protection 2 et qu'une deuxième portion 7b de la première partie 7 de l'enveloppe 5 reste solidaire des cellules photovoltaïques 4 (figures 7, 10, 12, 14, 19 à 22). Par ailleurs, l'étape de découpe E3-1 est telle qu'à son terme une première portion 8a de la deuxième partie 8 de l'enveloppe 5 reste solidaire du deuxième élément de protection 3, et qu'une deuxième portion 8b de la deuxième partie 8 de l'enveloppe 5 reste solidaire des cellules photovoltaïques 4 (figures 10, 12, 20, 21). La présence de ces premières et deuxièmes portions, adoptant par exemple la forme de couches, permet d'assurer que la découpe à l'aide du ou des fils abrasifs ne vienne pas altérer les cellules photovoltaïques 4 ainsi que les premier et deuxième éléments de protection 2, 3 en vue de faciliter par la suite leur recyclage.

Chaque fil abrasif 12, 18 utilisé pour participer au désassemblage du module photovoltaïque peut présenter un diamètre strictement inférieur à la distance de séparation entre le premier élément de protection 2 et les cellules photovoltaïque 4, ou le cas échant entre le deuxième élément de protection 3 et les cellules photovoltaïques 4 de sorte que le fil abrasif découpe uniquement du matériau d'encapsulation appartenant à l'enveloppe 5. Selon les gammes d'épaisseur présentées ci-avant pour les première et deuxième parties 7, 8, il est préféré que, pour le fil abrasif 12 et le cas échéant le fil abrasif additionnel 18, le diamètre du fil de support portant les particules abrasives du fil abrasif soit compris entre 40µm et 200µm, préférablement compris entre 100µm et 180µm, et idéalement de l'ordre de 150µm. Afin que la découpe de l'enveloppe 5 par fil abrasif 12, 18 soit rapide, il est préféré que les particules abrasives du fil abrasif soient de taille importante. La taille des particules abrasives utilisées pour former le fil abrasif 12 et/ou le fil abrasif additionnel 18 dépend du diamètre du fil de support devant les porter. Ainsi, par exemple, la taille des particules abrasives du fil abrasif peut être comprise entre 10µm et 50µm, et préférablement entre 30µm et 40µm pour un fil de support de diamètre égal à 150µm. Selon un exemple particulier, le fil de support 13 présente un diamètre de 180µm et les particules abrasives 14, notamment en diamant, présentent chacune une taille comprise entre 30µm et 40µm, cet exemple particulier permet de limiter le recollement de l'EVA sur lui-même au passage du fil abrasif 12, notamment en comparaison par rapport à un fil de support de 120µm. Selon cet exemple particulier, le fil de support 13 ayant un diamètre de 180µm peut être en acier et les particules abrasives 14 peuvent être formées par des diamants chacun de taille comprise entre 30µm et 40µm, un tel fil abrasif 12 présente les avantages suivants : il permet de découper rapidement ; on peut lui appliquer une forte tension lors de la découpe, par exemple de 40N, afin de bien contrôler la trajectoire du fil abrasif ; il évite à l'EVA de se recoller après le passage du fil abrasif ; il permet d'enlever environ 250µm de matière, ce qui peut être tout particulièrement adapté lorsque l'épaisseur de la partie de l'enveloppe dans laquelle doit passer le fil abrasif est d'environ 300µm car on retire ainsi, lors de la découpe correspondante, une épaisseur satisfaisante de l'enveloppe. Cet exemple particulier peut aussi s'appliquer au fil additionnel. La taille d'une particule abrasive peut être considérée comme son diamètre.

De manière générale, pour réaliser une découpe à l'aide d'un fil abrasif dans le cadre de la présente invention, l'outil de découpe 17, appartenant notamment au poste de découpe 16 décrit ci-avant, comporte des première et deuxième bobines 27, 28 (figures 6, 7, 9, 10, 11, 12, 13, 14 et 19 à 22), notamment respectivement appelées bobine débitrice et bobine réceptrice dans le domaine. L'outil de découpe 17 est configuré pour mettre en mouvement le fil abrasif 12 de sorte que celui-ci fasse des va-et-vient pour découper la partie concernée de l'enveloppe 5. Lorsque les étapes de découpes E2-1 et E3-1 sont réalisées par un même fil abrasif, il peut être utilisé une poulie de renvoi 29 du fil abrasif 12 entre les première et deuxième bobines 27, 28 (figures 9, 10 et 20). En cas d'utilisation d'un fil abrasif additionnel 18 pour l'étape de découpe E3-1, le même principe s'applique en associant ledit fil abrasif additionnel 18 à des première et deuxième bobines additionnelles 30, 31 (figures 11, 12 et 21).

Selon une réalisation particulière de l'outil de découpe 17, le fil abrasif 12 exécute, entre la première bobine 27 et la deuxième bobine 28, des allers-retours de telle sorte qu'à chaque retour du fil abrasif 12 en direction de la première bobine, la distance enroulée par la première bobine 27 est strictement inférieure à la distance déroulée par la première bobine 27 pour l'aller. Ceci permet avantageusement d'améliorer la durée de vie du fil abrasif 12 en renouvelant une partie longitudinale ce dernier à chaque aller-retour. En ce sens, à chaque aller-retour, il est possible de dérouler depuis la bobine débitrice entre 100m et 1500m, de préférence entre 500m et 1000m et idéalement entre 600m et 800m, de fil abrasif, et d'en enrouler en retour dans la bobine réceptrice par exemple que 99,1%, ou entre 95% et 99%, de la longueur déroulée. La vitesse linéaire du fil abrasif 12 peut varier de 10m/s à 30m/s lors de la découpe. Le cas échéant, le même principe peut s'appliquer pour les première et deuxième bobines 30, 31 associées au fil abrasif additionnel 18.

Tout ce qui a été décrit dans le cadre du procédé de désassemblage peut s'appliquer dans le cadre de l'installation de désassemblage et inversement. Notamment, l'installation de désassemblage comporte les moyens matériels, et le cas échéant logiciels, pour la mise en oeuvre du procédé de désassemblage.

Le procédé et l'installation décrits ci-avant trouvent une application industrielle dans le cadre du désassemblage d'un ou plusieurs modules photovoltaïques en vue de recycler leurs constituants. En effet, le cas échant, il est alors possible de récupérer le verre dans son intégralité si ce dernier n'est pas cassé, de récupérer le matériau comportant le polymère fluoré, de récupérer les éléments actifs du module photovoltaïque comme les cellules photovoltaïques qui pourraient être réutilisées. Ainsi, cela permet notamment de :
- réinjecter des panneaux de verre dans la fabrication de nouveaux modules photovoltaïques,
- de traiter les composés fluorés, si présents dans le premier élément de protection, dans une filière spécialisée des matériaux toxiques,
- de récupérer les métaux contenus dans les cellules photovoltaïques comme le silicium, l'argent, l'aluminium ou l'indium.

## Revendications

1. Procédé de désassemblage d'un module photovoltaïque (1) comportant :
• un premier élément de protection (2),
• un deuxième élément de protection (3),
• des cellules photovoltaïques (4) situées entre le premier élément de protection (2) et le deuxième élément de protection (3),
• une enveloppe (5) d'encapsulation des cellules photovoltaïques (4), ladite enveloppe (5) reliant le premier élément de protection (2) au deuxième élément de protection (3) et comportant :
∘ une première partie (7) située entre les cellules photovoltaïques (4) et le premier élément de protection (2), et
∘ une deuxième partie (8) située entre les cellules photovoltaïques (4) et le deuxième élément de protection (3),
ledit procédé de désassemblage comportant une étape de séparation (E2) des cellules photovoltaïques (4) par rapport au premier élément de protection (2), l'étape de séparation (E2) des cellules photovoltaïques (4) par rapport au premier élément de protection (2) comportant une étape de découpe (E2-1) de la première partie (7) de l'enveloppe (5) par un fil abrasif (12), **caractérisé en ce que** l'étape de découpe (E2-1) de la première partie (7) de l'enveloppe (5) par le fil abrasif (12) est réalisée à sec.

2. Procédé de désassemblage selon la revendication 1, **caractérisé en ce qu'**il comporte une étape de séparation (E3) des cellules photovoltaïques (4) par rapport au deuxième élément de protection (3), comportant une étape de découpe (E3-1) de la deuxième partie (8) de l'enveloppe (5).

3. Procédé de désassemblage selon la revendication précédente, **caractérisé en ce que** l'étape de découpe (E3-1) de la deuxième partie (8) de l'enveloppe (5) est mise en oeuvre par ledit fil abrasif (12) ou par un fil abrasif additionnel (18).

4. Procédé de désassemblage selon l'une quelconque des revendications précédentes, **caractérisé en ce que** le premier élément de protection (2) comportant des rebords (9a, 9b, 9c, 9d) en contact avec des bords latéraux (10a , 10b) de la première partie (7) de l'enveloppe (5), le procédé de désassemblage comporte une étape de retrait (E4) des rebords (9a, 9b, 9c, 9d) du premier élément de protection (2), l'étape de découpe (E2-1) de la première partie (7) de l'enveloppe (5) étant mise en oeuvre après l'étape de retrait (E4) des rebords (9a, 9b, 9c, 9d).

5. Procédé de désassemblage selon la revendication précédente, **caractérisé en ce que** l'étape de retrait (E4) des rebords comporte :
• une étape de formation (E4-1) d'une entaille (22) dans le module photovoltaïque (1) depuis une face extérieure du premier élément de protection (2) de sorte à délimiter un cadre (23) comportant les rebords (9a, 9b, 9c, 9d),
• une étape de découpe (E4-2) pratiquée dans des faces latérales du module photovoltaïque (1) jusqu'à l'entaille (22) en vue de désolidariser le cadre (23) du module photovoltaïque.

6. Procédé de désassemblage selon la revendication précédente, **caractérisé en ce que** l'étape de formation (E4-1) de l'entaille (22) et l'étape de découpe (E4-2) pratiquée dans les faces latérales du module photovoltaïque (1) sont réalisées par un faisceau (21a) de particules énergétiques issu d'une tête de découpe (21).

7. Procédé de désassemblage selon la revendication précédente, **caractérisé en ce qu'**au cours de l'étape de découpe (E4-2) pratiquée dans les faces latérales du module photovoltaïque (1), la tête de découpe (21) est guidée en utilisant des données issues d'un système de guidage (24) comportant un système de vision optique, ou un détecteur de matériau.

8. Procédé de désassemblage selon l'une quelconque des revendications 5 à 7, **caractérisé en ce qu'**au cours de l'étape de découpe (E4-2) pratiquée dans les faces latérales du module photovoltaïque (1), une action est exercée sur le cadre (23) par un organe de préhension de sorte à écarter ledit cadre (23) par rapport aux cellules photovoltaïques (4).

9. Procédé de désassemblage selon l'une quelconque des revendications précédentes, **caractérisé en ce que** l'étape de séparation (E2) des cellules photovoltaïques (4) par rapport au premier élément de protection (2) comporte une étape de sollicitation (E2-2) du premier élément de protection (2), ladite étape de sollicitation (E2-2) écartant progressivement, au cours de l'étape de découpe (E2-1) de ladite première partie (7) de l'enveloppe (5), ledit premier élément de protection (2) par rapport aux cellules photovoltaïques (4) au fur et à mesure de la progression du fil abrasif (12) dans la première partie (7) de l'enveloppe (5).

10. Procédé de désassemblage selon l'une quelconque des revendications précédentes, **caractérisé en ce qu'**il comporte une étape de refroidissement (E5) du module photovoltaïque (1), et **en ce que** l'étape de découpe (E2-1) de la première partie (7) de l'enveloppe (5) par le fil abrasif (12) est réalisée au cours de l'étape de refroidissement (E5) du module photovoltaïque (1).

11. Procédé de désassemblage selon l'une quelconque des revendications précédentes, **caractérisé en ce que** l'un des premier et deuxième éléments de protection (2, 3) est maintenu à plat lors de la mise en oeuvre de l'étape de découpe (E2-1) de la première partie (7) de l'enveloppe (5).

12. Procédé de désassemblage selon l'une quelconque des revendications précédentes, **caractérisé en ce que** le fil abrasif (12) comporte un fil de support (13) sur lequel sont fixées des particules abrasives (14).

13. Procédé de désassemblage selon la revendication précédente, **caractérisé en ce que** le diamètre du fil de support (13) est compris entre 40µm et 200µm, préférablement compris entre 100µm et 180µm, et/ou **en ce que** la taille des particules abrasives (14) est comprise entre 10µm et 50µm.

14. Procédé de désassemblage selon la revendication 12, **caractérisé en ce que** le fil de support (13) présente un diamètre de 180µm et les particules abrasives (14), notamment en diamant, présentent chacune une taille comprise entre 30µm et 40µm.

15. Procédé de désassemblage selon l'une des revendications 1 à 14, **caractérisé en ce que** l'enveloppe (5) d'encapsulation des cellules photovoltaïques (4) est à base d'Ethylène Acétate de Vinyle.

16. Installation de désassemblage d'un module photovoltaïque (1), ledit module photovoltaïque (1) comportant un premier élément de protection (2), un deuxième élément de protection (3), des cellules photovoltaïques (4) situées entre le premier élément de protection (2) et le deuxième élément de protection (3), une enveloppe (5) d'encapsulation des cellules photovoltaïques (4), ladite enveloppe (5) reliant le premier élément de protection (2) au deuxième élément de protection (3) et comportant :
• une première partie (7) située entre les cellules photovoltaïques (4) et le premier élément de protection (2), et
• une deuxième partie (8) située entre les cellules photovoltaïques (4) et le deuxième élément de protection (3),
ladite installation comportant un poste de découpe (16) du module photovoltaïque (1) comprenant un outil de découpe (17) muni d'un fil, **caractérisée en ce que** le fil est un fil abrasif (12) agencé de sorte à permettre une découpe à sec de la première partie (7) de l'enveloppe (5) en vue de séparer les cellules photovoltaïques (4) par rapport au premier élément de protection (2).

## Patentansprüche

1. Verfahren zur Demontage eines Photovoltaikmoduls (1), das Folgendes aufweist:
• ein erstes Schutzelement (2),
• ein zweites Schutzelement (3),
• Photovoltaikzellen (4), die sich zwischen dem ersten Schutzelement (2) und dem zweiten Schutzelement (3) befinden,
• eine Hülle (5) zum Einkapseln der Photovoltaikzellen (4), wobei die Hülle (5) das erste Schutzelement (2) mit dem zweiten Schutzelement (3) verbindet und Folgendes aufweist:
o einen ersten Teil (7), der sich zwischen den Photovoltaikzellen (4) und dem ersten Schutzelement (2) befindet, und
o einen zweiten Teil (8), der sich zwischen den Photovoltaikzellen (4) und dem zweiten Schutzelement (3) befindet,
wobei das Demontageverfahren einen Schritt des Trennens (E2) der Photovoltaikzellen (4) von dem ersten Schutzelement (2) aufweist, wobei der Schritt des Trennens (E2) der Photovoltaikzellen (4) von dem ersten Schutzelement (2) einen Schritt des Schneidens (E2-1) des ersten Teils (7) der Hülle (5) durch einen Schleifdraht (12) aufweist, **dadurch gekennzeichnet, dass** der Schritt des Schneidens (E2-1) des ersten Teils (7) der Hülle (5) durch den Schleifdraht (12) trocken durchgeführt wird.

2. Demontageverfahren nach Anspruch 1, **dadurch gekennzeichnet, dass** es einen Schritt des Trennens (E3) der Photovoltaikzellen (4) von dem zweiten Schutzelement (3) aufweist, der einen Schritt des Schneidens (E3-1) des zweiten Teils (8) der Hülle (5) aufweist.

3. Demontageverfahren nach dem vorhergehenden Anspruch, **dadurch gekennzeichnet, dass** der Schritt des Schneidens (E3-1) des zweiten Teils (8) der Hülle (5) durch den Schleifdraht (12) oder durch einen zusätzlichen Schleifdraht (18) durchgeführt wird.

4. Demontageverfahren nach einem der vorhergehenden Ansprüche, **dadurch gekennzeichnet, dass** das erste Schutzelement (2) Ränder (9a, 9b, 9c, 9d) aufweist, die mit den Seitenkanten (10a, 10b) des ersten Teils (7) der Hülle (5) in Kontakt stehen, das Demontageverfahren einen Schritt des Entfernens (E4) der Ränder (9a, 9b, 9c, 9d) des ersten Schutzelements (2) aufweist, wobei der Schritt des Schneidens (E2-1) des ersten Teils (7) der Hülle (5) nach dem Schritt des Entfernens (E4) der Ränder (9a, 9b, 9c, 9d) durchgeführt wird.

5. Demontageverfahren nach dem vorhergehenden Anspruch, **dadurch gekennzeichnet, dass** der Schritt des Entfernens (E4) der Ränder Folgendes aufweist:
• einen Schritt des Bildens (E4-1) einer Kerbe (22) in dem Photovoltaikmodul (1) von einer Außenseite des ersten Schutzelements (2) aus, um einen Rahmen (23) zu begrenzen, der die Ränder (9a, 9b, 9c, 9d) aufweist,
• einen Schritt des Schneidens (E4-2), der in den Seitenflächen des Photovoltaikmoduls (1) bis zur Kerbe (22) vorgenommen wird, um den Rahmen (23) vom Photovoltaikmodul zu trennen.

6. Demontageverfahren nach dem vorhergehenden Anspruch, **dadurch gekennzeichnet, dass** der Schritt des Bildens (E4-1) der Kerbe (22) und der Schritt des Schneidens (E4-2), der in den Seitenflächen des Photovoltaikmoduls (1) vorgenommen wird, durch einen Strahl (21 a) von Energiepartikeln durchgeführt wird, der von einem Schneidkopf (21) ausgeht.

7. Demontageverfahren nach dem vorhergehenden Anspruch, **dadurch gekennzeichnet, dass** während des Schritts des Schneidens (E4-2), der in den Seitenflächen des Photovoltaikmoduls (1) vorgenommen wird, der Schneidkopf (21) unter Verwendung von Daten geführt wird, die von einem Führungssystem (24) stammen, das ein optisches Bildverarbeitungssystem oder einen Materialdetektor aufweist.

8. Demontageverfahren nach einem der Ansprüche 5 bis 7, **dadurch gekennzeichnet, dass** während des Schritts des Schneidens (E4-2), der in den Seitenflächen des Photovoltaikmoduls (1) vorgenommen wird, durch ein Greiforgan eine Aktion auf den Rahmen (23) ausgeübt wird, so dass der Rahmen (23) in Bezug auf die Photovoltaikzellen (4) auseinandergezogen wird.

9. Demontageverfahren nach einem der vorhergehenden Ansprüche, **dadurch gekennzeichnet, dass** der Schritt des Trennens (E2) der Photovoltaikzellen (4) von dem ersten Schutzelement (2) einen Schritt des Beanspruchens (E2-2) des ersten Schutzelements (2) aufweist, wobei der Schritt des Beanspruchens (E2-2) während des Schritts des Schneidens (E2-1) des ersten Teils (7) der Hülle (5) das erste Schutzelement (2) in Bezug auf die Photovoltaikzellen (4) in dem Maße, in dem der Schleifdraht (12) in den ersten Teil (7) der Hülle (5) vordringt, allmählich beiseite schiebt.

10. Demontageverfahren nach einem der vorhergehenden Ansprüche, **dadurch gekennzeichnet, dass** es einen Schritt des Abkühlens (E5) des Photovoltaikmoduls (1) aufweist, und dass der Schritt des Schneidens (E2-1) des ersten Teils (7) der Hülle (5) durch den Schleifdraht (12) während des Schritts des Abkühlens (E5) des Photovoltaikmoduls (1) durchgeführt wird.

11. Demontageverfahren nach einem der vorhergehenden Ansprüche, **dadurch gekennzeichnet, dass** eines der ersten und zweiten Schutzelemente (2, 3) bei der Durchführung des Schritts des Schneidens (E2-1) des ersten Teils (7) der Hülle (5) flach gehalten wird.

12. Demontageverfahren nach einem der vorhergehenden Ansprüche, **dadurch gekennzeichnet, dass** der Schleifdraht (12) einen Trägerdraht (13) aufweist, an dem Schleifpartikel (14) befestigt sind.

13. Demontageverfahren nach dem vorhergehenden Anspruch, **dadurch gekennzeichnet, dass** der Durchmesser des Trägerdrahts (13) zwischen 40 µm und 200 µm liegt, vorzugsweise zwischen 100 µm und 180 µm, und/oder dass die Größe der Schleifpartikel (14) zwischen 10 µm und 50 µm liegt.

14. Demontageverfahren nach Anspruch 12, **dadurch gekennzeichnet, dass** der Trägerdraht (13) einen Durchmesser von 180 µm aufweist und die Schleifpartikel (14), insbesondere aus Diamant, jeweils eine Größe zwischen 30 µm und 40 µm aufweisen.

15. Demontageverfahren nach einem der Ansprüche 1 bis 14, **dadurch gekennzeichnet, dass** die Hülle (5) zum Einkapseln der Photovoltaikzellen (4) auf Ethylen-Vinylacetat-Basis ist.

16. Anlage zur Demontage eines Photovoltaikmoduls (1), wobei das Photovoltaikmodul (1) ein erstes Schutzelement (2), ein zweites Schutzelement (3), Photovoltaikzellen (4), die sich zwischen dem ersten Schutzelement (2) und dem zweiten Schutzelement (3) befinden, und eine Hülle (5) zum Einkapseln der Photovoltaikzellen (4) aufweist, wobei die Hülle (5) das erste Schutzelement (2) mit dem zweiten Schutzelement (3) verbindet und Folgendes aufweist:
• einen ersten Teil (7), der sich zwischen den Photovoltaikzellen (4) und dem ersten Schutzelement (2) befindet, und
• einen zweiten Teil (8), der sich zwischen den Photovoltaikzellen (4) und dem zweiten Schutzelement (3) befindet,
wobei die Anlage eine Station (16) zum Schneiden des Photovoltaikmoduls (1) aufweist, die ein mit einem Draht versehenes Schneidwerkzeug (17) aufweist, **dadurch gekennzeichnet, dass** der Draht ein Schleifdraht (12) ist, der so angeordnet ist, dass er ein trockenes Schneiden des ersten Teils (7) der Hülle (5) ermöglicht, um die Photovoltaikzellen (4) von dem ersten Schutzelement (2) zu trennen.

## Claims

1. Method for disassembling a photovoltaic module (1) comprising:
• a first protective element (2),
• a second protective element (3),
• photovoltaic cells (4) that are located between the first protective element (2) and the second protective element (3),
• an envelope (5) in which the photovoltaic cells (4) are encapsulated, said envelope (5) linking the first protective element (2) to the second protective element (3) and comprising:
∘ a first portion (7) that is located between the photovoltaic cells (4) and the first protective element (2), and
∘ a second portion (8) that is located between the photovoltaic cells (4) and the second protective element (3),
said disassembly method comprising a step (E2) of separating the photovoltaic cells (4) with respect to the first protective element (2), the step (E2) of separating the photovoltaic cells (4) with respect to the first protective element (2) comprising a step (E2-1) of cutting the first portion (7) of the envelope (5) by means of an abrasive wire (12), **characterized in that** the step (E2-1) of cutting the first portion (7) of the envelope (5) by means of the abrasive wire (12) is carried out in dry conditions.

2. Disassembly method according to Claim 1, **characterized in that** it comprises a step (E3) of separating the photovoltaic cells (4) with respect to the second protective element (3), comprising a step (E3-1) of cutting the second portion (8) of the envelope (5).

3. Disassembly method according to the preceding claim, **characterized in that** the step (E3-1) of cutting the second portion (8) of the envelope (5) is implemented by said abrasive wire (12) or by an additional abrasive wire (18).

4. Disassembly method according to any one of the preceding claims, **characterized in that** the first protective element (2) comprising rims (9a, 9b, 9c, 9d) in contact with lateral edges (10a, 10b) of the first portion (7) of the envelope (5), the disassembly method comprises a step (E4) of removing the rims (9a, 9b, 9c, 9d) from the first protective element (2), the step (E2-1) of cutting the first portion (7) of the envelope (5) being implemented after the step (E4) of removing the rims (9a, 9b, 9c, 9d).

5. Disassembly method according to the preceding claim, **characterized in that** the step (E4) of removing the rims comprises:
• a step (E4-1) of forming a notch (22) in the photovoltaic module (1) from an outer face of the first protective element (2) so as to delimit a frame (23) comprising the rims (9a, 9b, 9c, 9d),
• a step (E4-2) of cutting into the lateral faces of the photovoltaic module (1) up to the notch (22) in order to detach the frame (23) from the photovoltaic module.

6. Disassembly method according to the preceding claim, **characterized in that** the step (E4-1) of forming the notch (22) and the step (E4-2) of cutting into the lateral faces of the photovoltaic module (1) are carried out by a beam (21a) of energetic particles originating from a cutting head (21).

7. Disassembly method according to the preceding claim, **characterized in that** during the step (E4-2) of cutting into the lateral faces of the photovoltaic module (1), the cutting head (21) is guided by using data from a guiding system (24) comprising an optical vision system, or a material detector.

8. Disassembly method according to any one of Claims 5 to 7, **characterized in that** during the step (E4-2) of cutting into the lateral faces of the photovoltaic module (1), an action is exerted on the frame (23) by a gripping member so as to move said frame (23) away from the photovoltaic cells (4).

9. Disassembly method according to any one of the preceding claims, **characterized in that** the step (E2) of separating the photovoltaic cells (4) with respect to the first protective element (2) comprises a step (E2-2) of applying a force to the first protective element (2), said force application step (E2-2) gradually moving said first protective element (2) away from the photovoltaic cells (4), during the step (E2-1) of cutting said first portion (7) of the envelope (5), as the abrasive wire (12) progresses through the first portion (7) of the envelope (5).

10. Disassembly method according to any one of the preceding claims, **characterized in that** it comprises a step (E5) of cooling the photovoltaic module (1), and **in that** the step (E2-1) of cutting the first portion (7) of the envelope (5) by means of the abrasive wire (12) is carried out during the step (E5) of cooling the photovoltaic module (1).

11. Disassembly method according to any one of the preceding claims, **characterized in that** one of the first and second protective elements (2, 3) is held flat during the implementation of the step (E2-1) of cutting the first portion (7) of the envelope (5).

12. Disassembly method according to any one of the preceding claims, **characterized in that** the abrasive wire (12) comprises a support wire (13) to which abrasive particles (14) are fixed.

13. Disassembly method according to the preceding claim, **characterized in that** the diameter of the support wire (13) is between 40 µm and 200 µm, preferably between 100 µm and 180 µm, and/or **in that** the size of the abrasive particles (14) is between 10 µm and 50 µm.

14. Disassembly method according to Claim 12, **characterized in that** the support wire (13) has a diameter of 180 µm and the abrasive particles (14), which are notably made from diamond, each have a size of between 30 µm and 40 µm.

15. Disassembly method according to any one of Claims 1 to 14, **characterized in that** the envelope (5) in which the photovoltaic cells (4) are encapsulated is ethylene-vinyl acetate-based.

16. Installation for disassembling a photovoltaic module (1), said photovoltaic module (1) comprising a first protective element (2), a second protective element (3), photovoltaic cells (4) that are located between the first protective element (2) and the second protective element (3), an envelope (5) in which the photovoltaic cells (4) are encapsulated, said envelope (5) linking the first protective element (2) to the second protective element (3) and comprising:
• a first portion (7) that is located between the photovoltaic cells (4) and the first protective element (2), and
• a second portion (8) that is located between the photovoltaic cells (4) and the second protective element (3),
said installation comprising a cutting station (16) for cutting the photovoltaic module (1) comprising a cutting tool (17) provided with a wire, **characterized in that** the wire is an abrasive wire (12) arranged so as to allow the first portion (7) of the envelope (5) to be cut in dry conditions in order to separate the photovoltaic cells (4) with respect to the first protective element (2).
